# EUROPEAN PATENT APPLICATION

(11) **EP 4 307 447 A2**
(43) Date of publication of application: **17.01.2024**
(21) Application number: 23180550.8
(22) Date of filing: 21.06.2023
(51) Int. Cl.: H01M 50/211, H01M 10/42, H01M 10/48, H01M 50/247, H01M 50/284, H01M 50/287, H01M 50/289, H01M 50/296, H05K 1/02, H05K 1/05

(54) **BATTERY PACK**

(30) Priority: 21.06.2022 US 202263354032 P; 06.12.2022 US 202263430520 P
(71) Applicant: Milwaukee Electric Tool Corporation, Brookfield, WI 53005 (US)
(72) Inventor: SILHA, Wyatt R., Milwaukee, 53210 (US); CASTAÑOS, Carmen J., Milwaukee, 53202 (US); MEYER, Zachery, Hartland, 53029 (US); ZIDEL, Eli M., Milwaukee, 53211 (US); QUENZER, Jonathan D., German Valley, 61039 (US)
(74) Representative: Forresters IP LLP

(57) **Abstract**

A battery pack is configured to be coupled to an electrical device. The battery pack includes
a battery cell; a printed circuit board (PCB) having a metal base layer; and an intermediate layer positioned between the battery cell and the PCB, the intermediate layer including a first section formed of a first material and a second section formed of a second material, the first material having a lower thermal conductivity than the second material.

## Description

### BACKGROUND

The present disclosure relates to battery packs, and more specifically, to printed circuit boards (PCBs) for battery packs.

### SUMMARY

Cordless tools, such as power tools (e.g., drills, drivers, saws, nailers, grinders, etc.), outdoor tools (e.g., trimmers, pole saws, blowers, etc.), etc., and other electrical devices (e.g., motorized devices, non-motorized devices, chargers, etc.) (generally referred to herein as "devices" or a "device") are powered by a rechargeable battery pack. The battery pack may be detached from a device for charging or for use with other devices.

In one aspect, the disclosure provides a battery pack including a battery cell, a first PCB, and a second PCB. The first PCB is electrically connected to the battery cell. The first PCB includes an aluminum base layer. The second PCB is electrically connected to the first PCB. The second PCB is disposed on a side of the first PCB opposite that of the battery cell.

In another aspect, the disclosure provides a battery pack including a battery cell, a PCB, and an intermediate layer. The PCB has a metal base layer. The intermediate layer is positioned between the battery cell and the PCB. The intermediate layer includes a first section formed of a first material and a second section formed of a second material. The first material has a lower thermal conductivity than the second material.

Other independent aspects of the invention may become apparent by consideration of the detailed description and accompanying drawings.

### BRIEF DESCRIPTION OF THE DRAWINGS

FIG. 1 is a perspective view of a battery pack according to an embodiment of the disclosure.
FIG. 2A is a perspective view of an interior of the battery pack of FIG. 1.
FIG. 2B is a perspective view of another embodiment of the interior of the battery pack of FIG. 1.
FIG. 3 is a perspective view of the battery pack of FIG. 1 taken along line 3-3.
FIG. 4A is a perspective view of an interior housing for the battery pack of FIG. 1.
FIG. 4B is a perspective view of another embodiment of the interior housing for the battery pack of FIG. 1.
FIG. 4C is a perspective view of an interior housing that includes an endplate for the battery pack of FIG. 1
FIG. 5A is a perspective view of a pouch cell for the battery pack of FIG. 1.
FIG. 5B is a perspective view of a stack of pouch cells for the battery pack of FIG. 1.
FIG. 6 is a schematic view of a PCB for the battery pack of FIG. 1.
FIG. 7A is a perspective view of a PCB for the battery pack of FIG. 1.
FIG. 7B is a perspective view of an embodiment a first PCB and a second PCB of the battery pack of FIG. 1.
FIG. 8A is a top view of a PCB for the battery pack of FIG. 1.
FIG. 8B is a top view of another embodiment of a PCB for the battery pack of FIG. 1.
FIG. 9 is a schematic view of a portion of the interior of the battery pack of FIG. 2A.

### DETAILED DESCRIPTION

Before any embodiments of the invention are explained in detail, it is to be understood that the invention is not limited in its application to the details of construction and the arrangement of components set forth in the following description or illustrated in the following drawings. The invention is capable of other embodiments and of being practiced or of being carried out in various ways.

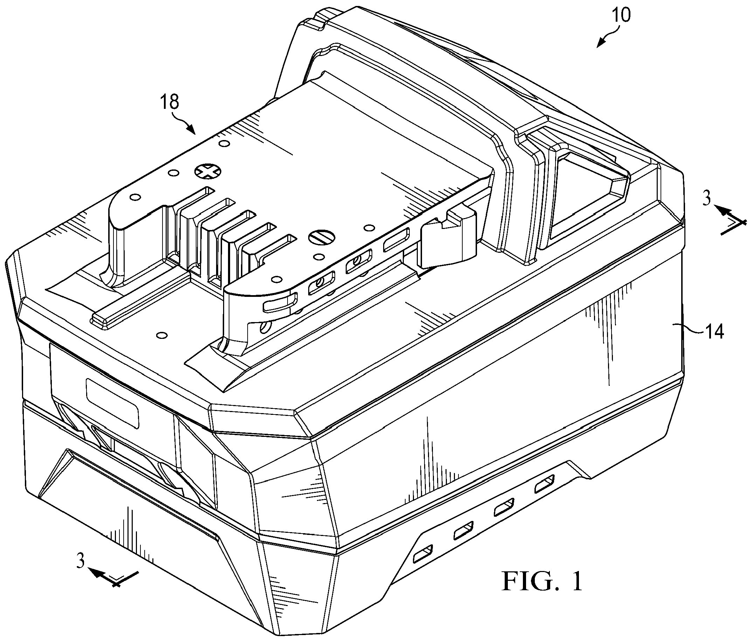

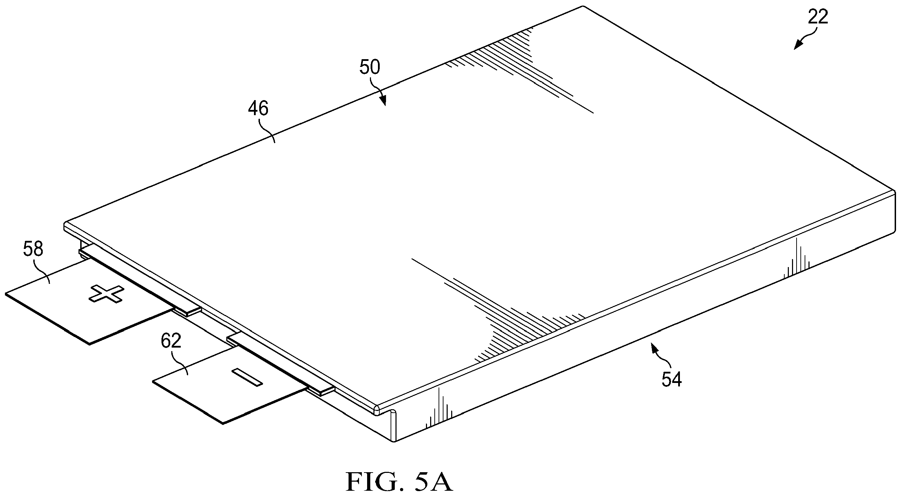

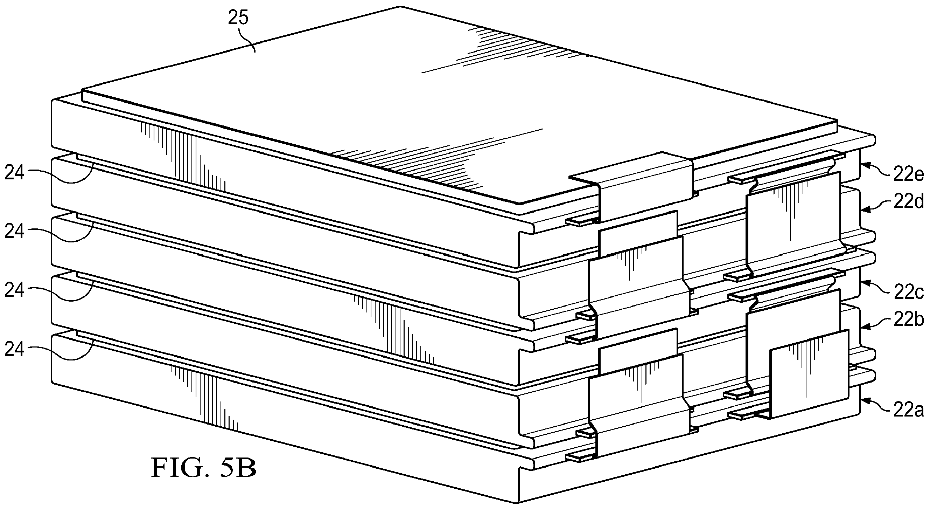

FIG. 1 illustrates a battery pack 10. The battery pack includes an exterior housing 14 with an output port 18 that may provide an electrical current to a device such as a power tool. The battery pack 10 includes a plurality of battery cells 22 (FIGS. 5A, 5B) for creating the electrical current. In the illustrated embodiment, the battery cells 22 (FIGS. 5A, 5B) are pouch cells. In other embodiments, the battery pack 10 may include lithium-ion battery cells, nickel-cadmium battery cells, or another similar battery cell.

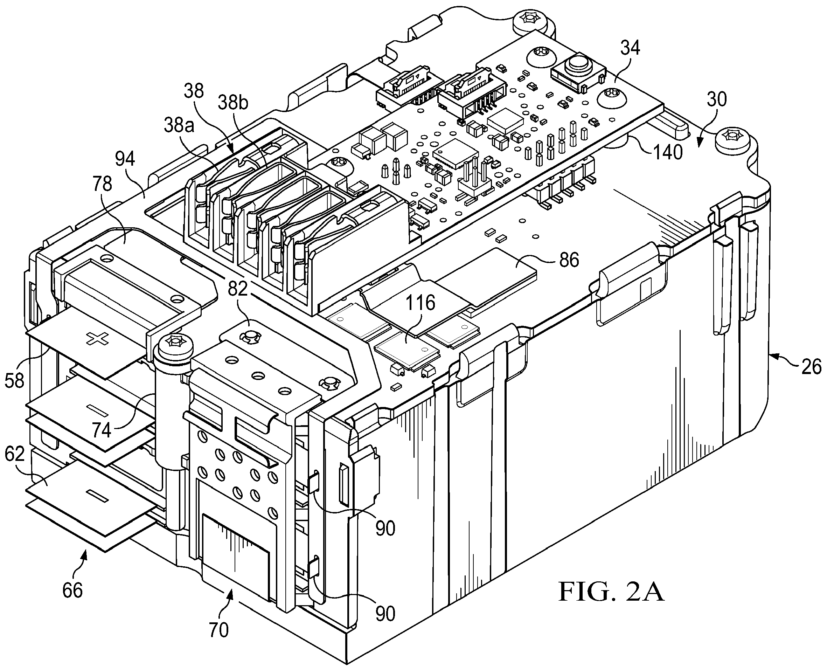

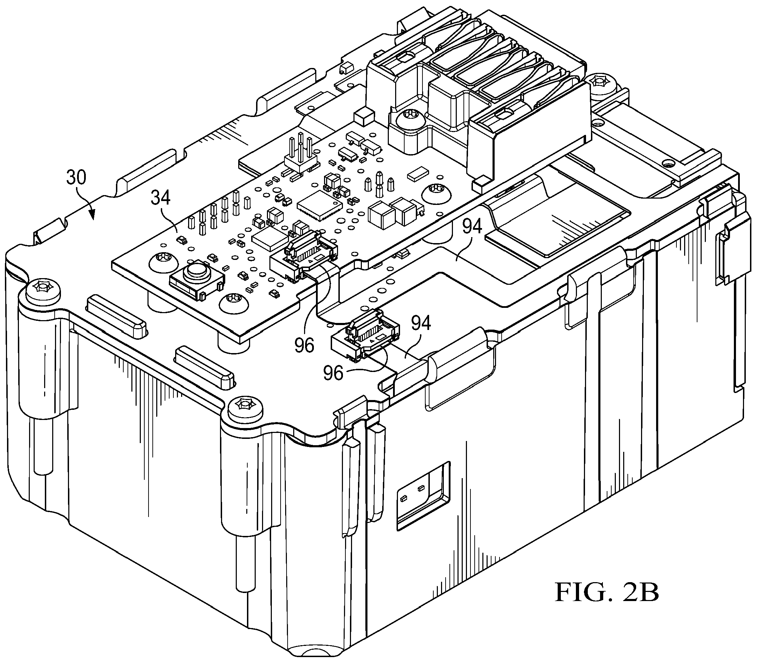

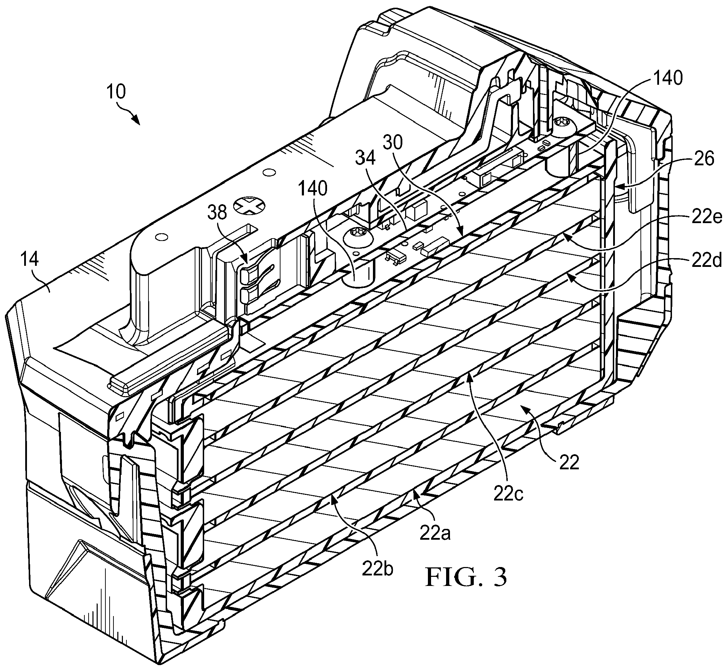

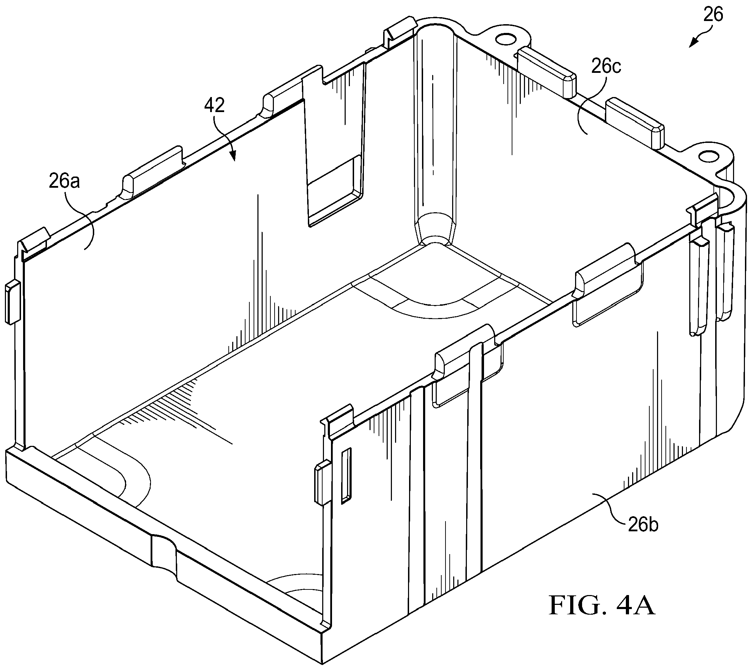

As illustrated in FIGS. 2 and 3, the battery pack 10 includes an interior housing 26, or alternatively referred to as a core box, that receives the plurality of pouch cells 22, a first PCB 30, a second PCB 34, and a terminal 38. With reference to FIG. 4A, in the illustrated embodiment, the interior housing 26 includes three walls 26a, 26b, 26c that partially define at least one opening 42. With additional reference to FIG. 2A, the first PCB 30 contacts the three walls 26a, 26b, 26c of the interior housing 26. In other words, the first PCB 30 substantially covers the at least one opening 42 such that the first PCB 30 forms a surface of the interior housing 26. Returning reference to FIGS. 2 and 3, the second PCB 34 is disposed on a side of the first PCB 30 opposite that of the pouch cells 22. Stated another way, the first PCB 30 is positioned between the pouch cells 22 and the second PCB 34. The terminal 38 is mounted to the second PCB 34 and is positioned to align with the output port 18 (FIG. 1) for outputting an electrical current from the output port 18 (FIG. 1) to the device.

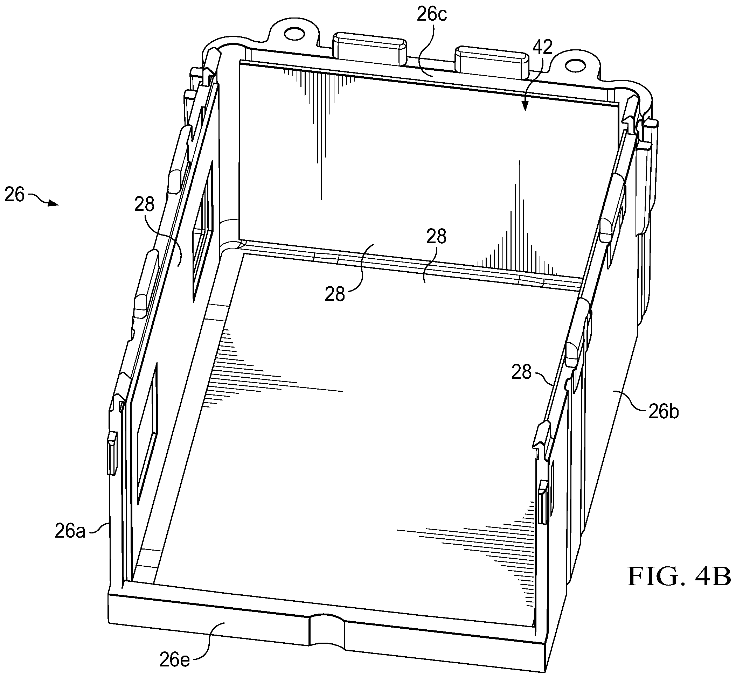

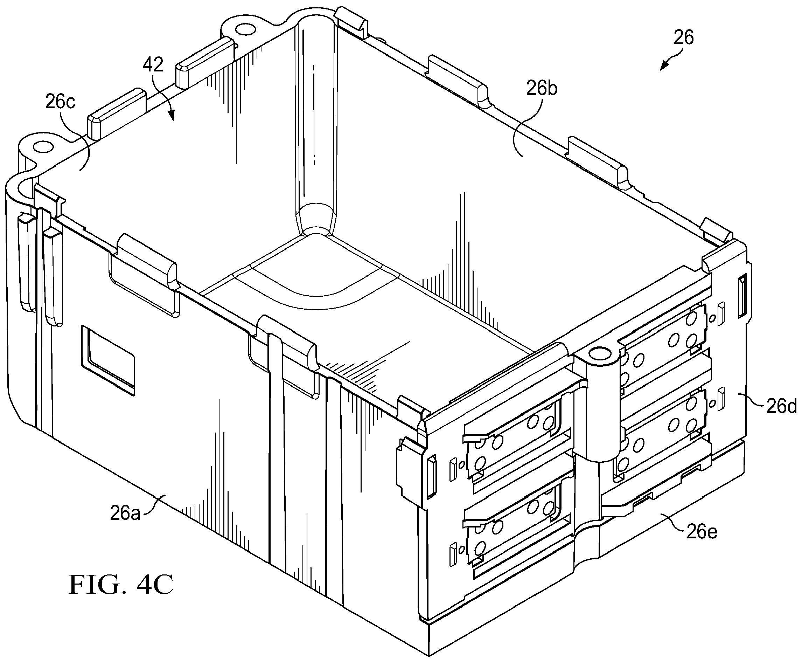

With reference to FIG. 4B, in the illustrated embodiment, the interior housing 26 again includes three walls 26a, 26b, 26c that partially define at least one opening 42. In the illustrated embodiment, a compressible lining 28 is affixed (e.g., with adhesive) to the interior side of each of the three walls 26a, 26b, 26c as well as top side of the bottom portion 26e of the interior housing 26. In some embodiments, the interior housing 26 includes an endplate 26e as the fourth wall defining the at least one opening 42 (see Fig. 4C). In some embodiments, the compressible lining 28 is affixed to the interior side of the endplate 26e and/or the bottom pouch cell 22a (FIG. 5B). In some embodiments, the compressible lining 28 includes foam. In some embodiments, the compressible lining 28 mitigates electrolyte leakage and protects pouch seams in impact scenarios. In some embodiments, the compressible linings 28 include adhesive on both the top and bottom sides, which adhere to the compressible linings 28 both the sides wall 26a, 26b, 26c, the bottom portion 26e, or the endplate 26e and the stack of pouch cells 22a-22e (FIG 5B).

With reference to FIG. 5A, the pouch cell 22 is one of a plurality of pouch cells 22, although just one pouch cell 22 is illustrated in FIG. 5A. In the illustrated embodiment, the battery pack 10 (FIG. 1) includes five pouch cells 22. In other embodiments, the battery pack 10 (FIG. 1) may include more than five pouch cells 22. In further embodiments, the battery pack 10 (FIG. 1) may include less than five pouch cells 22. As illustrated in FIG. 5A, each pouch cell 22 includes a body 46, first side 50, a second side 54, a positive cell tab 58, and a negative cell tab 62. The positive cell tab 58 and the negative cell tab 62 extend from the first side 50 of the pouch cell 22 away from the body 46.

Returning reference to FIGS. 2 and 3, the five pouch cells 22 are arranged in a stack within the interior housing 26. A first pouch cell 22a positioned furthest from the first PCB 30 is oriented such that the first side 50 (FIG. 5A) of the first pouch cell 22a faces the first PCB 30. A second pouch cell 22b, the next pouch cell 22 in the stack, is oriented such that the first side 50 (FIG. 5A) of the second pouch cell 22b faces the first pouch cell 22a and the second side 54 (FIG. 5A) of the second pouch cell 22b faces the first PCB 30. A third pouch cell 22c is oriented such that the first side 50 (FIG. 5A) of the third pouch cell 22c faces the first PCB 30, a fourth pouch cell 22d is oriented such that the first side 50 (FIG. 5A) of the fourth pouch cell 22d faces away from the first PCB 30, and a fifth pouch cell 22e is oriented such that the first side 50 (FIG. 5A) of the fifth pouch cell 22e faces the first PCB 30. As such, the plurality of pouch cells 22 is received in the interior housing 26 with alternating orientations in which the first side 50 (FIG. 5A) of every other pouch cell 22 faces the first PCB 30.

With reference to FIG. 5B, in the illustrated embodiment, an adhesive gap pad 24 is included between each of the stack of pouch cells 22a-22e. In some embodiments, the top side and the bottom side of the gap pad 24 includes adhesive, which adhere to the each of the respective pouch cells 22. In some embodiments, the gap pad 24 includes foam. In the illustrated embodiment, a top pad 25 is positioned on the top pouch cell 22e. In some embodiments, the top pad 25 includes adhesive on the side attached to the top pouch cell 22e. In some embodiments, the top pad 25 includes adhesive on the top side, which adheres to the bottom side of the first PCB 30 (not shown). In some embodiments, an adhesive sheet (not shown) is attached to the bottom of the bottom pouch cell 22a. In some embodiments, the adhesive sheet is attached directly to the bottom portion 26e of the interior housing 26 (not shown) or to the compressible lining 28 that is attached to the bottom portion 26e (not shown). The adhesive gap pads 24, the top pad 25, and the adhesive sheet prevents the pouch cells 22 from puffing up and expanding.

With continued reference to FIGS. 2 and 3, the stack of pouch cells 22a-22e within the interior housing 26 creates a first column of cell tabs 66 and a second column of cells tabs 70. For pouch cells 22a, 22c, 22e oriented with the first side 50 (FIG. 5A) of the pouch cell 22a, 22c, 22e facing the first PCB 30, the positive cell tab 58 is positioned in the first column 66 and the negative cell tab 62 is positioned in the second column 70. For pouch cells 22b, 22d oriented with the second side 54 (FIG. 5A) of the pouch cell 22b, 22d facing the first PCB 30, the negative cell tab 62 is positioned in the first column 66 and the positive cell tab 58 is positioned in the second column 70. As such, the first column 66 includes three positive cell tabs 58 and two negative cell tabs 62, and the second column 70 includes three negative cell tabs 62 and two positive cell tabs 58. The first column 66 has a net positive charge, and the second column 70 has a net negative charge.

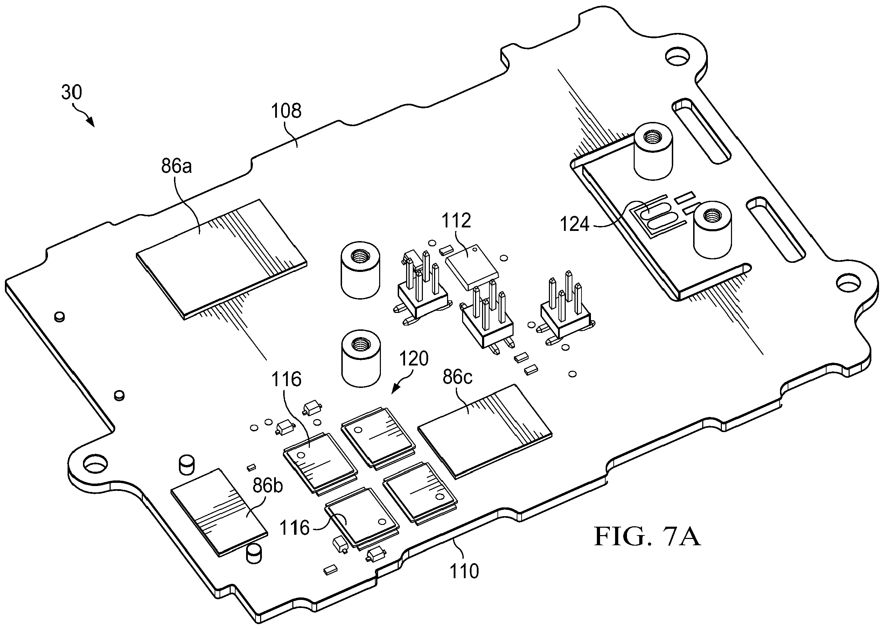

The battery pack 10 further includes a positive cell strap 78, a negative cell strap 82, a plurality of connection pads 86 (although just one connection pad 86 is illustrated in FIG. 2A), a plurality of voltage taps 90, and a flex circuit 94. The positive cell strap 78 is electrically connected to the first column of cell tabs 66 and thus has a net positive charge. The negative cell strap 82 is electrically connected to the second column of cell tabs 70 and thus has a net negative charge. The positive cell strap 78 is welded to a first connection pad 86a (FIG. 7A) to provide an electrical and thermal connection between the positive cell strap 78 and the first PCB 30. The negative cell strap 82 is welded to a second connection pad 86b (FIG. 7A) to provide an electrical and thermal connection between the negative cell strap 82 and the first PCB 30. The plurality of voltage taps 90 between the cell tabs 58, 62 measure a voltage output of the pouch cells 22a-22e. The voltage taps 90 relay the voltage measurement to the flex circuit 94. The flex circuit 94 then directs the voltage measurement to the first PCB 30. In some embodiments, the flex circuit 94 is connected to the first PCB 30 and/or the second PCB 34 via a respective locking connector 96 (see FIG. 2B) to reduce the amount of glue keep terminal contacts clear.

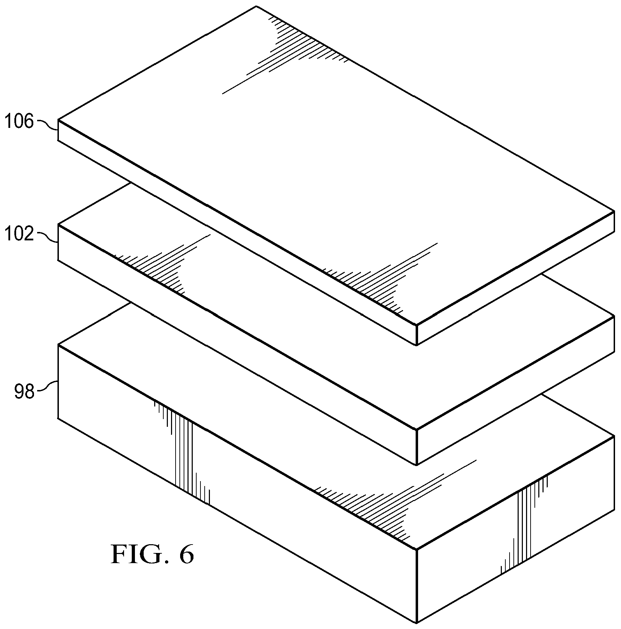

Turning reference to FIG. 6, the first PCB 30 (FIG. 2A) is formed of at least a metal base layer 98, a dielectric layer 102, and a circuit copper layer 106. In the illustrated embodiment, the metal base layer 98 includes aluminum. The dielectric layer 102 is positioned between the metal base layer 98 and the circuit copper layer 106. The dielectric layer 102 includes thermally conductive and electrically insulating material. The circuit copper 106 layer provides an electrical connection across a surface of the first PCB 30 (FIG. 2A) between components mounted to the first PCB 30 (FIG. 2A) as will later be described. With reference to FIG. 7A, the first PCB 30 further includes a first surface 108 and a second surface 110 opposite the first surface 108. The second surface 110 is closer to the pouch cells 22a-22e (FIG. 3) than the first surface 108.

Returning reference to FIG. 6, in the illustrated embodiment, the metal base layer 98 may be formed of a metal having a thermal conductivity of at least 80 Watts per meter-Kelvin (W/mK). In other embodiments, the metal base layer 98 may be formed of a metal having a thermal conductivity of at most 260 W/mK. In further embodiments, the metal base layer 98 may be formed of a metal having a thermal conductivity that is in a range of 80 W/mK to 260 W/mK. In the illustrated embodiment, the metal base layer 98 may be formed of up to 25% of aluminum. In other embodiments, the metal base layer 98 may be formed of up to 50% of aluminum. In further embodiments, the metal base layer 98 may be formed of up to 75% of aluminum. In even further embodiments, the metal base layer 98 may be formed entirely of aluminum. In the illustrated embodiment, the metal base layer 98 may be formed of an aluminum alloy such as aluminum alloy 6061, aluminum alloy 3003, aluminum alloy 1100, or another similar aluminum alloy.

As illustrated in FIG. 7A, the first PCB 30 includes a plurality of electrical components mounted thereon on. The plurality of electrical components includes, at least, a charge field-effect transistor 112, a discharge field-effect transistor 116, and a sense resistor 120. The charge field-effect transistor 112 and the discharge field-effect transistor 116 are operable to control and direct a flow of current through the first PCB 30. Specifically, the charge field-effect transistor 112 may control a level and direction of current flow across the copper circuit layer 106 of the first PCB 30. The charge field-effect transistor 112 controls current flow while the battery pack 10 is being charged. The first PCB 30 may include a plurality of charge field-effect transistors 112. The discharge field-effect transistor 116 may also control a level and direction of current flow across the copper circuit layer 108 of the first PCB 30. The discharge field-effect transistor 116 controls current flow being discharged from the battery pack 10 (e.g., to a power tool). The first PCB 30 may include a plurality of discharge field-effect transistors 116. The sense resistor 120 may be used to detect and measure a current level through the first PCB 30 as controlled by the charge field-effect transistor 112 and the discharge field-effect transistor 116. The first PCB 30 further includes at least one thermistor 124 mounted thereon. More specifically, the first PCB 30 includes a plurality of thermistors 124. The thermistor 124 is configured to detect and measure a temperature of the battery pack 10. The plurality of thermistors 124 enables fault tolerance of the battery pack 10, such that if one thermistor 124 fails, the battery pack 10 (FIG. 3) has backup thermistors 124.

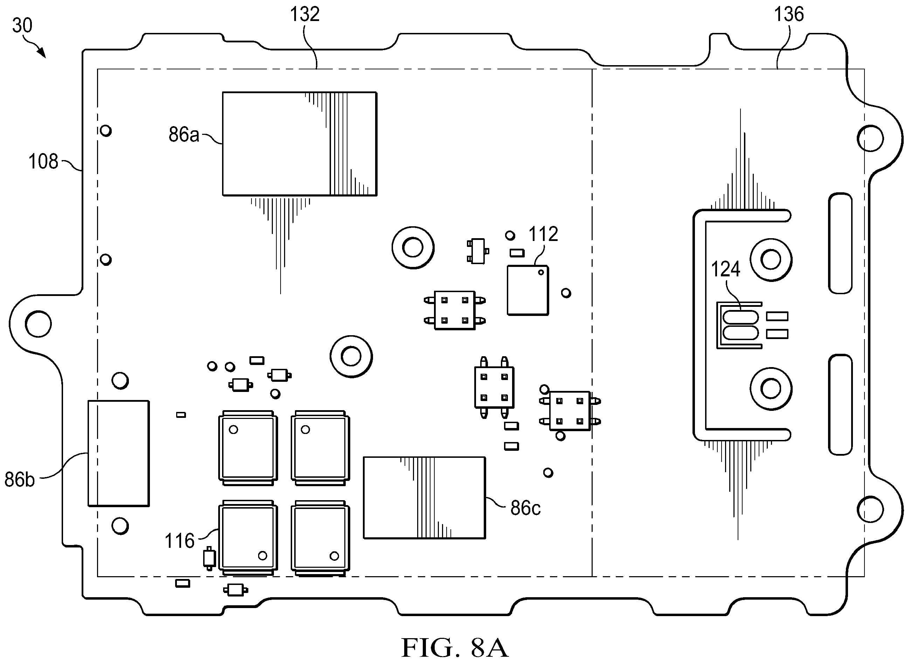

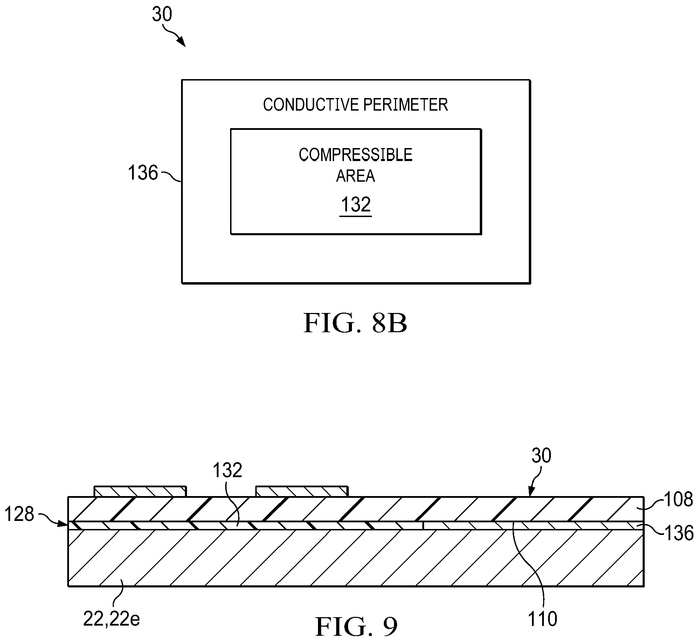

With reference to FIGS. 8A, 8B, and 9, the battery pack 10 (FIG. 3) further includes an intermediate layer 128 that is positioned between the pouch cells 22 and the first PCB 30. The intermediate layer 128 includes a first section 132 formed of a first material and a second section 136 formed of a second material. The first material has a lower thermal conductivity than the second material. As such, the first material is a thermally insulating material (e.g., fiberglass, polyurethane foam, etc.), and the second material is a thermally conductive material (e.g., graphite, zinc, etc.). Therefore, heat generated by the pouch cells 22 may be thermally insulated from the first PCB 30 in areas of the first PCB 30 that overlap, or cover, the first section 132 of the intermediate layer 128. Additionally, heat generated by the pouch cells 22 may be thermally conducted to the first PCB 30 in areas of the first PCB 30 that overlap, or cover, the second section 136 of the intermediate layer 128. The first section 132 of the intermediate layer 128 covers more than half of the second surface 110 of the first PCB 30. In the embodiment illustrated in FIG 8A, the first section 132 of the intermediate layer 128 covers roughly 2/3 of the second surface 110 of the first PCB 30. In other embodiments, the first section 132 of the intermediate layer 128 may overlap with less than 2/3 of the second surface 110 of the first PCB 30. In further embodiments, the first section 132 of the intermediate layer 128 may overlap with more than 2/3 of the second surface 110 of the first PCB 30. In the embodiment illustrated in FIG 8B, the first section 132 of the intermediate layer 128 forms the interior portion of the first PCB 30 and the second section 136 of the intermediate layer 128 form the perimeter portion of the first PCB 30. In some embodiments, the first section 132 is an inner compressible pad and the second section 136 is an outer conductive perimeter. The embodiment illustrated in FIG. 8B allow for the middle between cells to compress (cells expand more in the middle) but still allow for heat to transfer along the edges. In some embodiments, the inner compressible pad is removed to reduce weight.

With continued reference to FIGS. 8A, 8B, and 9, the electrical components (e.g., the charge field-effect transistor 112, the discharge field-effect transistor 116, and the sense resistor 120), the positive cell strap 78 (FIG. 2A), and the negative cell strap 82 (FIG. 2A), which are mounted on the first PCB 30, may generate or conduct heat during use of the battery pack 10. As such, the metal base layer 98 (FIG. 6) of the first PCB 30 provides a heatsink for any component of the battery pack 10 (FIG. 1) that generates heat. In other words, the metal base layer 98 (FIG. 6) dissipates heat from the electrical components, the positive cell strap 78 (FIG. 2A), and the negative cell strap 82 (FIG. 2A) to inhibit overheating of the battery pack 10 (FIG. 1). Each of the electrical components (e.g., the charge field-effect transistor 112, the discharge field-effect transistor 116, and the sense resistor 120) is coupled to the first PCB 30 opposite the first PCB 30 from the first section 132 of the intermediate layer 128. Additionally, both the positive cell strap 78 (FIG. 2A) and the negative cell strap 82 (FIG. 2A) are coupled to the first PCB 30 opposite the first PCB 30 from the first section 132 of the intermediate layer 128. As such, the first section 132 of the intermediate layer 128 further inhibits the electrical components and the cell straps 78, 82 (FIG. 2A) from overheating by inhibiting thermal conduction between the pouch cells 22 and the first PCB 30. Conventional battery packs do not include an aluminum PCB and thus require an additional heatsink to draw heat away from the electrical components and the cell straps 78, 82 (FIG. 2A). As such, the first PCB 30 enables a reduction in size of the battery pack 10 (FIG. 1).

The at least one thermistor 124 is coupled to the first PCB 30 opposite the first PCB 30 from the second section 136 of the intermediate layer 128. The second section 136 of the intermediate layer 128 enables thermal conduction between the pouch cells 22 and the first PCB 30. The first PCB 30 therefore has substantially the same temperature as the pouch cells 22 in areas of the first PCB 30 that cover, or overlap, the second section 136 of the first PCB 30. As such, at least one thermistor 124 may be placed directly on the first surface 108 of the first PCB 30 to get an accurate reading of the true temperature of the battery pack 10 (FIG. 1). Conventional battery packs have PCBs that are not as thermally conductive as the first PCB 30 and thus do not reach temperatures similar to the temperature of the battery cells. Therefore, thermistors 124 placed on the PCB of a conventional battery pack would inadequately detect and measure the true temperature of said conventional battery pack.

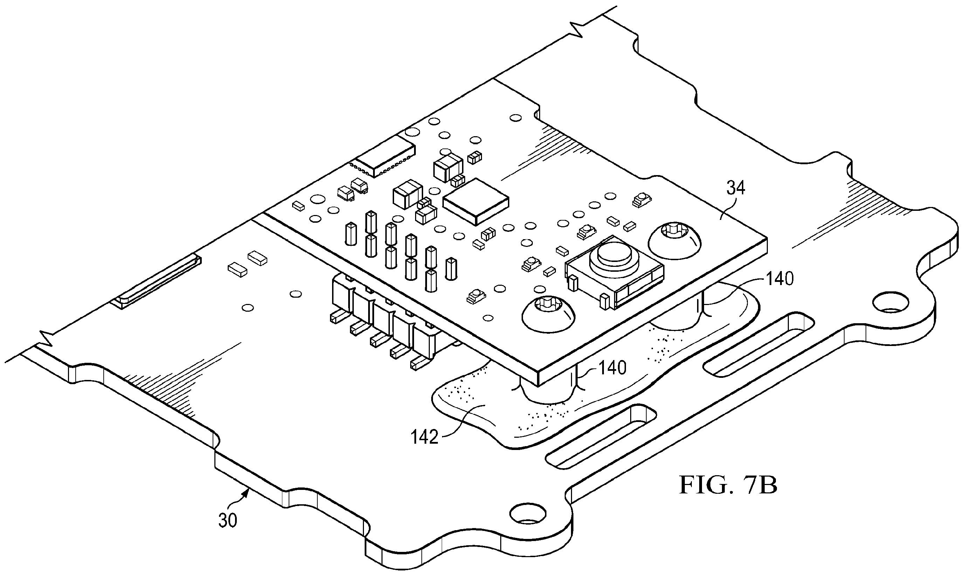

Returning reference to FIGS. 2 and 3, the second PCB 34 is mounted to the first PCB 30. Specifically, the second PCB 34 is mounted to the first PCB 30 opposite the first PCB 30. As such, the first PCB 30 is positioned between the pouch cells 22 and the second PCB 34. The battery pack 10 includes a plurality of posts 140 for mounting the second PCB 34 to the first PCB 30. The plurality of posts 140 offsets the second PCB 34 from the first PCB 30 such that a space is defined therebetween. One of the posts 140 extends from the first PCB 30 through the second PCB 34 and the terminal 38, thereby securing the terminal 38 to the second PCB 34. In the embodiment illustrated in FIG. 7B, at least one of the plurality of posts 140 is attached to the first PCB 30 and the second PCB 34 with epoxy 142.

In some embodiments, the second PCB 34 is an FR-4 PCB. As such, the second PCB 34 includes a thin layer of copper foil that may be laminated or surface welded to each side of a glass epoxy panel. In the illustrated embodiment, the second PCB 34 includes no aluminum. In other embodiment, the second PCB 34 may include some aluminum. In even further embodiments, the second PCB 34 may be formed identical to the first PCB 30.

With continued reference to FIGS. 2 and 3, the terminal 38 is mounted to the second PCB 34 and is electrically connected to both the first PCB 30 and the second PCB 34. A current loop created by the positive cell strap 78 and the negative cell strap 82 passes through the terminal 38. As such, the terminal 38 includes a positive terminal 38a and a negative terminal 38b. The terminal 38 may output an electrical current from the battery pack 10 to a device such as a power tool. Both the positive terminal 38a and the negative terminal 38b are electrically connected to the first PCB 30 and the second PCB 34. The terminal 38 electrically and thermally connects to the first PCB 30 at the first connection pad 86a and a third connection pad 86c. More specifically, the positive terminal 38a electrically and thermally connects to the first PCB 30 by welding or soldering to the first connection pad 86a. The negative terminal 38b electrically and thermally connects to the first PCB 30 by welding or soldering to the third connection pad 86c. The thermal connection of the terminals 38a, 38b to the aluminum first PCB 30 provides a heat sink for the terminals 38a, 38b, and thus, inhibits the terminals 38a, 38b from rising to inoperable or potentially damaging temperatures. In some embodiments, the terminal 38 is soldered to the second PCB 34. In some embodiments, the terminal 38 is laser welded to the first PCB 30 to provide a much stronger and thermally robust connection.

Various components of the described embodiments of the interior of the battery pack 10, including the stack of pouch cells 22a-22e, as well as the entire interior may be sprayed with a coating material, such as a polymer. In some embodiments, the coating material is heated before being sprayed on the various components of the interior of the battery pack 10. In some embodiments, the coating material is dried in an exothermic reaction after spraying. In some embodiments, the coating material allows the stack of pouch cells 22a-22e to expand and/or contract during use. In some embodiments, the coating material help maintain the integrity (i.e., helps hold the pouch cells together) of the stack of pouch cells 22a-22e thereby limiting how much they cells can swell.

Although the disclosure has been described in detail with reference to certain preferred embodiments, variations and modifications exist within the scope and spirit of one or more independent aspects of the disclosure as described.

### Example Configurations

Various aspects of the present disclosure may take any one or more of the following example configurations:
EEE(1) A battery pack comprising a battery cell; a first PCB electrically connected to the battery cell, the first PCB including an aluminum base layer; and a second PCB electrically connected to the first PCB, the second PCB disposed on a side of the first PCB opposite that of the battery cell.
EEE(2) The battery pack according to EEE(1), further comprising a thermal insulation layer positioned at least partially between the PCB and the battery cell.
EEE(3) The battery pack according to EEE(1) or EEE(2), wherein the second PCB includes no aluminum.
EEE(4) The battery pack according to any one of EEE(1) to EEE(3), wherein the battery cell is a pouch cell.
EEE(5) The battery pack according to any one of EEE(1) to EEE(4), further comprising a terminal that outputs an electrical current, the terminal mounted to the second PCB.
EEE(6) The battery pack according to any one of EEE(1) to EEE(5), wherein the battery cell is one of a plurality of battery cells.
EEE(7) The battery pack according to any one of EEE(1) to EEE(6), wherein an inner housing of the battery pack contains the plurality of battery cells.
EEE(8) The battery pack according to any one of EEE(1) to EEE(7), wherein the first PCB contacts three walls of the inner housing.
EEE(9) The battery pack according to any one of EEE(1) to EEE(8), wherein a compressible lining is affixed each of the three walls of the inner housing and in contact with the plurality of battery cells.
EEE(10) The battery pack according to any one of EEE(1) to EEE(9), wherein a gap pad is positioned between each of the plurality of battery cells.
EEE(11) The battery pack according to any one of EEE(1) to EEE(10), wherein a gap pad is affixed to each of the adjacent battery cells.
EEE(12) The battery pack according to any one of EEE(1) to EEE(11), wherein a top pad is affixed to a top battery cell of the plurality of battery cells.
EEE(13) The battery pack according to any one of EEE(1) to EEE(12), further comprising a coating material covering the first PCB, the second PCB, and the plurality of battery cells.
EEE(14) The battery pack according to any one of EEE(1) to EEE(13), wherein the coating material includes a polymer.
EEE(15) The battery pack according to any one of EEE(1) to EEE(14), wherein the second PCB is mounted to the first PCB.
EEE(16) The battery pack according to any one of EEE(1) to EEE(15), wherein the second PCB is offset from the first PCB by a plurality of posts.
EEE(17) The battery pack according to any one of EEE(1) to EEE(16), wherein each of the plurality of posts is affix to the first PCB with epoxy.
EEE(22) The battery pack according to any one of EEE(1) to EEE(17), further comprising a positive cell strap electrically connected to the first PCB.
EEE(19) The battery pack according to any one of EEE(1) to EEE(22), wherein the aluminum base layer of the first PCB dissipates heat from the positive cell strap.
EEE(20) The battery pack according to any one of EEE(1) to EEE(19), further comprising a negative cell strap electrically connected to the first PCB.
EEE(21) The battery pack according to any one of EEE(1) to EEE(20), wherein the aluminum base layer of the first PCB dissipates heat from the negative cell strap.
EEE(22) A battery pack comprising a battery cell; a PCB having a metal base layer; and an intermediate layer positioned between the battery cell and the PCB, the intermediate layer including a first section formed of a first material and a second section formed of a second material, the first material having a lower thermal conductivity than the second material.
EEE(23) The battery pack according to EEE(22), further comprising a sense resistor coupled to the PCB opposite the PCB from the first section of the intermediate layer.
EEE(24) The battery pack according to EEE(22) or EEE(23), further comprising a field-effect transistor coupled to the PCB opposite the PCB opposite from the first section of the intermediate layer.
EEE(25) The battery pack according to any one of EEE(22) to EEE(24), further comprising a thermistor coupled to the PCB opposite the PCB from the second section of the intermediate layer.
EEE(26) The battery pack according to any one of EEE(22) to EEE(25), wherein the thermistor is one of a plurality of thermistors coupled to the PCB opposite the PCB from the second section of the intermediate layer.
EEE(27) The battery pack according to any one of EEE(22) to EEE(26), wherein the PCB further includes a first surface and a second surface opposite the first surface.
EEE(28) The battery pack according to any one of EEE(22) to EEE(27), wherein the second surface is closer to the battery cell than the first surface.
EEE(29) The battery pack according to any one of EEE(22) to EEE(28), wherein the first section of the intermediate layer covers more than half of the second surface of the PCB.
EEE(30) The battery pack according to any one of EEE(22) to EEE(29), wherein the first section of the intermediate layer covers two-thirds of the second surface of the PCB.
EEE(31) The battery pack according to any one of EEE(22) to EEE(30), wherein the PCB further includes a first surface forming an interior portion and a second surface forming a perimeter portion.
EEE(32) The battery pack according to any one of EEE(22) to EEE(31), wherein the metal base layer has a thermal conductivity that is in a range of 80 W/mK to 260 W/mK.
EEE(33) The battery pack according to any one of EEE(22) to EEE(32), wherein the metal base layer includes aluminum.
EEE(34) The battery pack according to any one of EEE(22) to EEE(33), further comprising a positive cell strap and a negative cell strap coupled to the PCB opposite the PCB from the first section of the intermediate layer.

## Claims

1. A battery pack comprising:
a battery cell;
a first printed circuit board (PCB) electrically connected to the battery cell, the first PCB including an aluminum base layer; and
a second PCB electrically connected to the first PCB, the second PCB disposed on a side of the first PCB opposite that of the battery cell.

2. The battery pack of claim 1, further comprising a thermal insulation layer positioned at least partially between the PCB and the battery cell.

3. The battery pack of claim 1, wherein the second PCB includes no aluminum, and wherein the battery cell is a pouch cell.

4. The battery pack of claim 1, further comprising a terminal that outputs an electrical current, the terminal mounted to the second PCB.

5. The battery pack of claim 1, further comprising a coating material covering the first PCB, the second PCB, and a plurality of battery cells, wherein the coating material includes a polymer, wherein the battery cell is one of the plurality of battery cells, wherein an inner housing of the battery pack contains the plurality of battery cells, wherein the first PCB contacts three walls of the inner housing, wherein a compressible lining is affixed each of the three walls of the inner housing and in contact with the plurality of battery cells, wherein a gap pad is positioned between each of the plurality of battery cells, wherein the gap pad is affixed to each of the adjacent battery cells, and wherein a top pad is affixed to a top battery cell of the plurality of battery cells.

6. The battery pack of claim 1, wherein the second PCB is mounted to the first PCB, the second PCB is offset from the first PCB by a plurality of posts, and each of the plurality of posts is affix to the first PCB with epoxy.

7. The battery pack of claim 1, further comprising:
a positive cell strap electrically connected to the first PCB, wherein the aluminum base layer of the first PCB dissipates heat from the positive cell strap, and
a negative cell strap electrically connected to the first PCB, wherein the aluminum base layer of the first PCB dissipates heat from the negative cell strap.

8. A battery pack comprising:
a battery cell;
a printed circuit board (PCB) having a metal base layer; and
an intermediate layer positioned between the battery cell and the PCB, the intermediate layer including a first section formed of a first material and a second section formed of a second material, the first material having a lower thermal conductivity than the second material.

9. The battery pack of claim 8, further comprising a sense resistor coupled to the PCB opposite the PCB from the first section of the intermediate layer.

10. The battery pack of claim 8, further comprising a field-effect transistor coupled to the PCB opposite the PCB opposite from the first section of the intermediate layer.

11. The battery pack of claim 8, further comprising a thermistor coupled to the PCB opposite the PCB from the second section of the intermediate layer, wherein the thermistor is one of a plurality of thermistors coupled to the PCB opposite the PCB from the second section of the intermediate layer.

12. The battery pack of claim 8, wherein the PCB further includes a first surface and a second surface opposite the first surface, wherein the second surface is closer to the battery cell than the first surface, wherein the first section of the intermediate layer covers more than half of the second surface of the PCB, and wherein the first section of the intermediate layer covers two-thirds of the second surface of the PCB.

13. The battery pack of claim 8, wherein the PCB further includes a first surface forming an interior portion and a second surface forming a perimeter portion.

14. The battery pack of claim 8, wherein the metal base layer includes aluminum and has a thermal conductivity that is in a range of 80 Watts per meter-Kelvin (W/mK) to 260 W/mK.

15. The battery pack of claim 8, further comprising a positive cell strap and a negative cell strap coupled to the PCB opposite the PCB from the first section of the intermediate layer.
